# EUROPEAN PATENT SPECIFICATION

(11) **EP 4 443 498 B1**
(45) Date of publication and mention of the grant of the patent: **21.01.2026**
(21) Application number: 24167596.6
(22) Date of filing: 28.03.2024
(51) Int. Cl.: H01L 23/498, H01L 23/31, H01L 21/48, H01L 23/538, H01L 23/00, H01L 21/56, H01L 23/495, H01L 21/683

(54) **LEADLESS SEMICONDUCTOR PACKAGE WITH DUAL-SIDED STUD STRUCTURE FOR DIE-TO-PACKAGE FAN OUT**
LEITUNGSLOSES HALBLEITERGEHÄUSE MIT DOPPELSEITIGER BOLZENSTRUKTUR FÜR FAN-OUT VON CHIP ZU GEHÄUSE
BOÎTIER DE SEMI-CONDUCTEUR SANS FIL AVEC STRUCTURE DE GOUJON DOUBLE FACE POUR SORTANCE DE PUCE À BOÎTIER

(30) Priority: 07.04.2023 US 202318131929
(43) Date of publication of application: 09.10.2024
(73) Proprietor: NXP B.V., 5656 AG Eindhoven (NL)
(72) Inventor: CHUANG, Wen Yuan, 5656AG Eindhoven (NL); MAO, Kuan-Hsiang, 5656AG Eindhoven (NL); HUANG, Wen Hung, 5656AG Eindhoven (NL)
(74) Representative: Colaiuda, Antonella

(56) References cited:
- US-A1- 2014 335 658
- US-A1- 2015 021 751
- US-A1- 2017 005 058
- US-A1- 2019 148 270

## Description

### BACKGROUND

Flat leadless packages, such as quad-flat no-leads (QFN) packages and dual-flat no-leads (DFN) packages, are surface mount (SMT) semiconductor packages that encapsulate one or more integrated circuit (IC) die and provide electrical connections between the IC die and a printed circuit board (PCB) or other circuit board via conductive structures extending from the IC die to conductive pads (or lands) on the "bottom" surface of the package. In some conventional packaging technologies, these conductive structures utilize either wire bonds and a lead frame or one or more redistribution layers (RDLs) to fan-out connections from the IC die to corresponding pads at the "bottom surface" of the package. However, conventional fan-out approaches utilizing RDLs often result in package surface mount pads that are relatively thin and thus difficult to fabricate with solder wettable sidewalls. The resulting package thus may be unsuitable for use automotive, aeronautic, and other high-reliability implementations in which leads with wettable sidewalls provide for both improved solder distribution as well as providing a visual reference for the quality of solder joints during device inspection.

US2017/0005058 A1 discloses a leadless semiconductor package, which comprises an integrated circuit (110), several encapsulating layers (116, 114, 126), a first pillar structure (112) and a second pillar structure (124). A method for manufacturing such leadless semiconductor package is disclosed too. US 2015/0021751A1 discloses a leadless semiconductor package, comprising an integrated circuit, plated pillars (113) coupled to conductive leads (120) and encapsulating layer (140). The document discloses a method for manufacturing such leadless semiconductor package too.

US2014/0335658A1 discloses a semiconductor device and a method of manufacturing such device. The semiconductor device is a leadless semiconductor device, comprising an integrated circuit, electrically conductive layer (22), conductive pillar (28) and interconnected pillar structure (78). US2019/0148270A1 describes a leadless semiconductor device having a semiconductor die connected to several pads. Some of those pads show solder wettable flanks at an exterior sidewall.

### SUMMARY OF EMBODIMENTS

The present disclosure may be better understood with reference to the following examples, which may be considered individually or in various combinations.

Example 1: A leadless semiconductor package including an integrated circuit (IC) die having one or more contacts at an active surface facing a mounting surface of the leadless semiconductor package, and a plurality of dual-sided stud structures providing electrical connectivity between the IC die and the mounting surface, each dual-sided stud structure having at least one first conductive pillar structure extending from a corresponding contact at the active surface to a redistribution layer and having at least one second conductive pillar structure extending from a redistribution layer to an edge of the mounting surface, each first conductive pillar structure having a first dimension in a direction parallel to the mounting surface that is less than a corresponding second dimension of each second conductive pillar structure.

The leadless semiconductor package includes a first encapsulant layer encapsulating the active surface of the IC die and the first pillar structures of the plurality of dual-sided stud structures, and a second encapsulant layer encapsulating the second pillar structures of the plurality of dual-sided stud structures and forming a portion of the mounting surface.

Each second conductive pillar structure includes a solder wettable flank at an exterior sidewall.

Example 2: The leadless semiconductor package of Example 1, further including solder plating on exterior surfaces of the second conductive pillar structures that are parallel to the mounting surface and on surfaces of the solder wettable flanks of the second conductive pillar structures.

Example 3: The leadless semiconductor package of Example 1, wherein the second dimension is at least two times larger than the first dimension.

Example 4: The leadless semiconductor package of Example 1, wherein the second dimension is at least three times larger than the first dimension.

Example 5: An electronic device including a circuit board having the leadless semiconductor package of Example 1 mounted thereon.

Example 6: A leadless semiconductor package including a first surface and an opposing second surface, an integrated circuit (IC) die disposed adjacent to the first surface, and a conductive fan-out structure to provide contact fan-out from a plurality of contacts of an active surface of the IC die to the second surface of the leadless semiconductor package, the conductive fan-out structure including a plurality of thick pillar structures, each thick pillar structure extending into the leadless semiconductor package from an edge of the second opposing surface, wherein exposed surfaces of the thick pillar structures serve as surface mounting pads for the leadless semiconductor package, and a plurality of thin pillar structures, each thin pillar structure extending into the leadless semiconductor package from a corresponding contact of the plurality of contacts and electrically connected to at least one thick pillar structure via at least one redistribution layer, wherein the thick pillar structures are at least two times as thick as the thin pillar structures.

Example 7: The leadless semiconductor package of Example 6, wherein each second conductive pillar structure includes a solder wettable flank formed at an exterior sidewall.

Example 9: The leadless semiconductor package of Example 6, further including at least one encapsulant layer encapsulating the plurality of thin pillar structures and the plurality of thick pillar structures.

Example 10: An electronic device including a circuit board having the leadless semiconductor package of Example 6 mounted thereon.

Example 11: A method of fabricating a leadless semiconductor package, the method including forming a plurality of first pillar structures extending from contacts at an active surface of an integrated circuit (IC) die, encapsulating the IC die and the plurality of first pillar structures in a first encapsulant layer, forming one or more redistribution layers at a surface of the first encapsulant layer opposite the IC die, the one or more redistribution layers having metallizations electrically and mechanically connected to one or more corresponding first pillar structures of the first plurality of pillar structures, forming a plurality of second pillar structures extending from the one or more redistribution layers, each second pillar structure electrically connected to one or more first pillar structures via at least one redistribution layer and having a second dimension in a direction parallel to the active surface that is greater than a corresponding first dimension of each first conductive pillar structure, encapsulating the plurality of second pillar structures in a second encapsulant layer, and planarizing the second encapsulant layer and the plurality of second pillar structures to form a mounting surface for the leadless semiconductor package with exposed surfaces of the plurality of the second pillar structures serving as surface mount pads for the leadless semiconductor package.

Example 12: The method of Example 11, further including forming solder wettable flanks in exposed sidewalls of the plurality of second pillar structures.

Example 13: The method of Example 11, further including solder plating exposed surfaces of the plurality of the second pillar structures including the solder wettable flanks.

Example 14: The method of Example 11, further including forming a reconstructed panel including a plurality of workpieces including a workpiece representing the leadless semiconductor package, singulating the reconstructed panel after planarizing the second encapsulant layer and the plurality of second pillar structures to generate a plurality of leadless semiconductor packages from the plurality of workpieces, and wherein forming the solder wettable flanks includes forming grooves along singulation lines in metal material representing second pillar structures from adjacent workpieces prior to singulating the reconstructed panel.

Example 15: The method of Example 14, wherein forming grooves includes at least one of: performing chemical etches to form the grooves, or performing singulation cuts to partial depth to form the grooves.

Example 16: The method of Example 11, wherein the second dimension is at least two times the first dimension.

Example 17: The method of Example 11, wherein the second dimension is at least three times the first dimension.

Example 18: A leadless semiconductor package formed in accordance with the method of Example 11.

### BRIEF DESCRIPTION OF THE DRAWINGS

The present disclosure also is better understood, and its numerous features and advantages made apparent to those skilled in the art, by referencing the accompanying drawings. The use of the same reference symbols in different drawings indicates similar or identical items.
FIG. 1 is a diagram illustrating cross-section view of a leadless semiconductor package utilizing dual-sided stud structures for connection fan-out in accordance with some embodiments.
FIG. 2 is a diagram illustrating a bottom view of the leadless semiconductor package of FIG. 1 in accordance with some embodiments.
FIG. 3 is a diagram illustrating a cross-section view of an electronic device having the leadless semiconductor package of FIGs. 1 and 2 mounted on a circuit board in accordance with some embodiments.
FIGs. 4 and 5 are diagrams that together illustrate a method of fabrication of a leadless semiconductor package having dual-sided stud structures in accordance with some embodiments.

### DETAILED DESCRIPTION

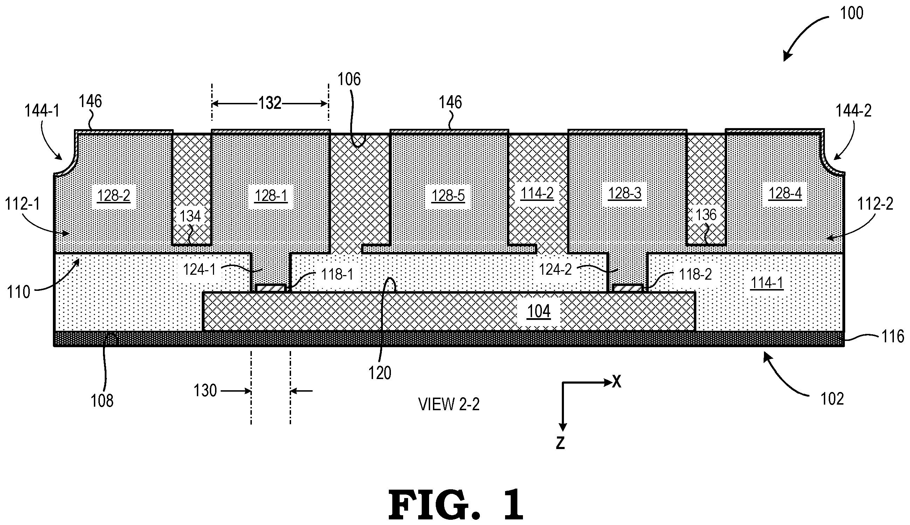

Conventional QFN, DFN, and other flat no-lead semiconductor package configurations utilize either wire bonding structures or RDL structures that often lead to surface mount pads that are not well suited for sidewall wettability. Moreover, these conventional fan-out structures often do not provide significant mechanical or structural support for the semiconductor package. They also often do not provide significant radio frequency (RF) or other electromagnetic (EM) insulation from the circuit board to which the package is mounted. FIGs. 1-5 below illustrate embodiments of a leadless semiconductor package (e.g., a QFN or DFN) having dual-sided stud structures that enable contact fan-out between an IC die and the mounting surface of the package, while also providing surface mount pads with wettable sidewalls and which provide mechanical support and EM isolation for the package. Each dual-sided stud structure includes at least one conductive "thin" pillar structure extending from a contact on the active surface of the embedded IC die to one or more RDL metallizations (e.g., metal lines/traces and/or vias) of the package, and further includes at least one conductive "thick" pillar structure extending from the one or more RDL metallizations to the mounting surface of the package. The thin pillar structures(s), thick pillar structures(s), and one or more RDL metallizations are electrically and mechanically connected, thereby forming one or more conductive paths between the contact(s) on the active surface and the mounting surface of the IC package. The thin pillar structures of the dual-sided stud structures have lateral dimension(s) compatible with the dimension scale of the active surface of the IC die and contacts thereon, while the thick pillar structures of the dual-sided stud structures have significantly larger lateral dimension(s) compatible with the significantly larger dimensional scale of the mounting surface of the package. This allows the dual-sided stud structures to provide die-to-package surface contact fanout, while also allowing the thick pillar structures to be processed at the mounting surface to incorporate solder wettable flanks along their exposed sidewall edges so as to facilitate sidewall wettability. Moreover, this thin-to-thick dual-sided stud structure provides for improved mechanical rigidity of the IC package, while also providing for EM isolation due to the relative height of the dual-sided stud structures as well as the volume of EM-insulating metal they provide between the IC die and the mounting surface of the package.

Note that in the following, certain orientational terms, such as top, bottom, front, back, lateral, vertical, thin, thick, wide, and the like, are used in a relative sense to describe the positional relationship of various components. These terms are used with reference to the relative position of components either as shown in the corresponding figure or as used by convention in the art and are not intended to be interpreted in an absolute sense with reference to a field of gravity. Thus, for example, a surface shown in the drawing and referred to as a top surface of a component would still be properly understood as being the top surface of the component, even if, in implementation, the component was placed in an inverted position with respect to the position shown in the corresponding figure and described in this disclosure. Further, note that certain positional terms, such as co-planar or parallel, will be understood to be interpreted in the context of fabrication tolerances or industry standards. For example, co-planar shall be understood to mean co-planar within applicable tolerances as a result of one or more fabrication processes affecting the components indicated to be co-planar, or co-planar within a tolerance utilized in the appropriate industry or fabrication technology. Moreover, it will be appreciated that for simplicity and clarity of illustration, components shown in the figures have not necessarily been drawn to scale. For example, the dimensions of some of the components may be exaggerated relative to other components in order to facilitate understanding of associated aspects.

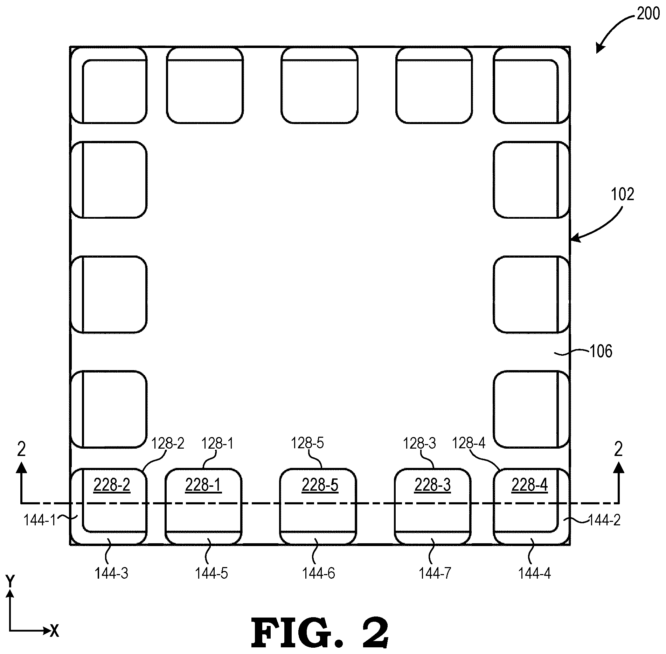

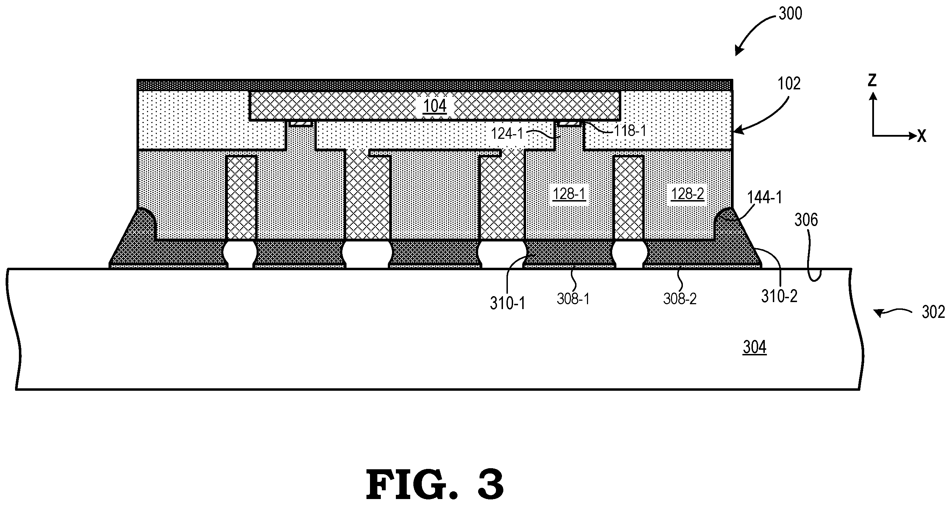

FIG. 1 illustrates a cross-section view 100 along a cutline 2-2 (FIG. 2) of a leadless semiconductor package 102 (hereinafter, "package 102") employing dual-sided stud structures for die-to-surface fan-out connectivity and package surface mounting in accordance with some embodiments. The package 102 encapsulates one or more IC die 104 and is configured to surface mount to a printed circuit board (PCB) or other circuit board of an electronic device (see FIG. 3). In particular, the package 102 implements a flat, no-lead package configuration in which the surface mount pads (or "leads") are implemented on the periphery of a bottom surface 106 of the package 102, such as a QFN package configuration.

As shown, the package 102 has the bottom surface 106 and an opposing surface 108, with the bottom surface 106 serving as the mounting surface by which the package 102 is mounted to a PCB or other circuit board of an electronic device (not shown in FIG. 1). As such, the bottom surface 106 is referred to herein as the "mounting surface 106" and the opposing surface 108 referred to herein as the "top surface 108." In the depicted embodiment, the package 102 is composed of a stack of structures/layers, including the one or more IC die 104, a fan-out structure 110 comprising one or more dual-sided stud structures 112 (such as the illustrated dual-sided stud structures 112-1 and 112-2), and one or more encapsulant layers 114 (such as the illustrated encapsulant layers 114-1 and 114-2) extending between the mounting surface 106 and the top surface 108 of the package 102. Further, in some embodiments, a backside lamination (BSL) layer 116 may be disposed at the top surface 108.

The fan-out structure 110 utilizes the one or more dual-sided stud structures 112 to provide fan-out electrical connectivity between contacts 118 (e.g., contacts 118-1 and 118-2) at an active surface 120 of the IC die 104 and corresponding surface mount pads (see FIG. 2) at the mounting surface 106 of the package 102. Each dual-sided stud structure 112 includes at least one first pillar structure 124 extending between a corresponding contact 118 and a facing metallization (e.g., a metal line or trace) of one or more RDLs of the package 102, and at least one second pillar structure 128 extending from the mounting surface 106 and a facing metallization of the one or more RDLs of the package 102. The first pillar structures (s) 124, the second pillar structures(s) 128, and trace(s), via(s), and other metallizations of the RDL(s) electrically and mechanically connect the first pillar structures (s) to the second pillar structures (s) in a given dual-sided stud structure 112 are composed of one or more metals, metal alloys, or oxides thereof, other conductive materials, or combinations thereof, such as copper (Cu), aluminum (Al), silver (Ag), gold (Au), titanium (Ti), and alloys (e.g., an iron (Fe)-nickel (Ni) alloy), or oxides thereof.

The first pillar structures 124 and second pillar structures 128 can have any of a variety of cross-sectional shapes, including a circular or elliptical cross-section, a rectangular or substantially rectangular cross-section, a stadium (or pill-shaped) cross-section, an n-sided polygonal cross-section, or the like, and the cross-section shape employed for the first pillar structures 124 may be the same or different from that employed for the second pillar structures 128. To facilitate die-to-package fan-out, the first pillar structures 124 have lateral dimensions suitable to the lateral dimensional scale of the active surface 120 of the IC die 104, whereas the second pillar structures 128 have lateral dimensions suitable to the lateral dimensional scale of the mounting surface 106 of the package 102. For purposes of this disclosure, the term "lateral" refers to a direction parallel to either or both of the plane formed by the active surface 120 of the IC die 104 or the plane formed by the mounting surface 106 of the package 102. For example, the second pillar structures 128 may have a second lateral dimension 132 in the indicated X-direction that is substantially larger than the corresponding first lateral dimension 130 of the second pillar structure 128 in the X-direction. In some embodiments, substantially larger in this sense means at least 50% larger (that is, the second lateral dimension 132 >= 150% of the first lateral dimension 130). In other embodiments, substantially larger in this sense means at least twice as large (that is, the second lateral dimension 132 >= 200% of the first lateral dimension 130). In still other embodiments, substantially larger in this sense means at least three times as large (that is, the second lateral dimension 132 >= 300% of the first lateral dimension 130). To put it another way, the second pillar structures 128 have a cross-sectional area substantially greater than a cross-sectional area of the first pillar structures 128, such as, in some embodiments, at least twice the cross-sectional area, and in other embodiments, at least three times the cross-sectional area. Accordingly, the first pillar structures 124 are referred to herein as "thin pillar structures 124" and the second pillar structures 128 are referred to herein as "thick pillar structures 128" in view of the relative difference in their corresponding lateral dimensions.

To illustrate, in the depicted example of FIG. 1, the dual-sided stud structure 112-1 includes a thin pillar structure 124-1 extending between (and electrically coupled to) a contact 118-1 at the active surface 120 and a thick pillar structure 128-1. The thick pillar structure 128-1 extends between the RDL(s) of the package and the mounting surface 106. The dual-sided stud structure 112-1 further includes another thick pillar structure 128-2 electrically and mechanically coupled to the thin pillar structure 124-1 and the thick pillar structure 128-1 via a metal trace 134 (one example of an RDL metallization) of an RDL of the package 102. The dual-sided stud structure 112-2 includes a thin pillar structure 124-2 extending between (and electrically coupled to) a contact 118-2 at the active surface 120 and a thick pillar structure 128-3. The thick pillar structure 128-3 extends between the RDL(s) of the package and a corresponding edge of the mounting surface 106. The dual-sided stud structure 112-2 further includes another thick pillar structure 128-4 electrically and mechanically coupled to the thin pillar structure 124-2 and the thick pillar structure 128-3 via a metal trace 136 of an RDL of the package 102. The exposed external surfaces of the thick pillar structures 128-1, 128-2 and 128-3, 128-4 at the mounting surface 106 and sidewalls of the package 102 thus form the surface mount pads (also known as "terminal pads" or "mounting pads") for electrically and mechanically coupling the dual-sided stud structures 112-1 and 112-2, respectively, to corresponding pads of a PCB or other circuit board. The example cross-section view 100 also depicts a fifth thick pillar structure 128-5, which may be part of a third dual-sided stud structure 112 that extends in the Y-direction relative to the X-Z orientation of cross-section view 100, or which may be implemented as a dummy stud for heat transfer, mechanical integrity, or EM isolation purposes.

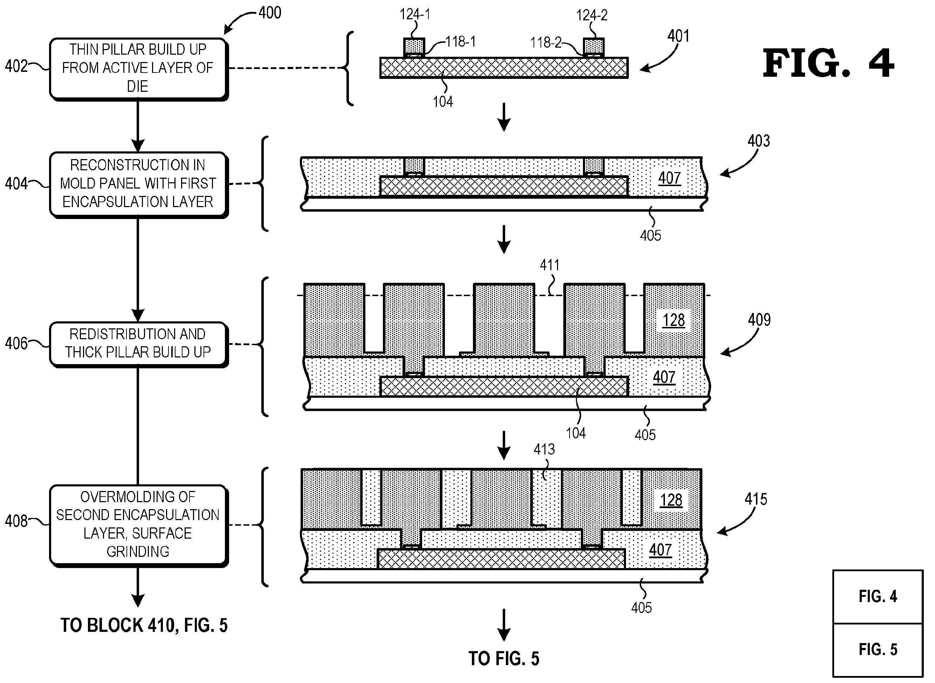

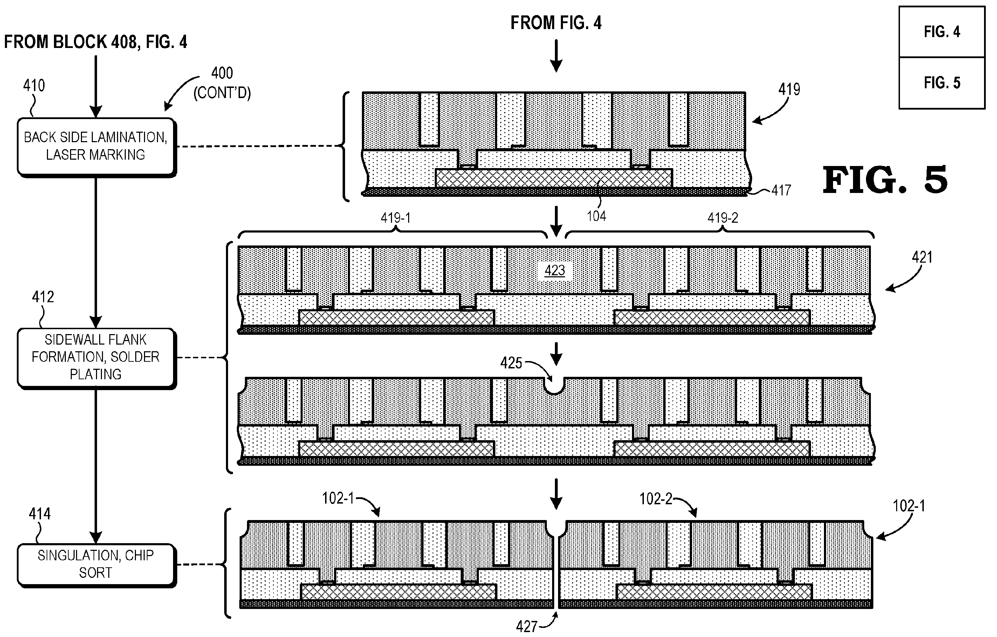

The package 102 further includes one or more encapsulant layers 114 to encapsulate the IC die 104, the thin pillar structures 124, the thick pillar structures 128, and the one or more RDLs. As described in greater detail below with reference to FIGs. 4 and 5, in at least one embodiment the package 102 is fabricated using two molding steps: a first molding step in which the thin pillar structures 124 are formed at the active surface of the IC die 104 and then the IC die 104 and thin pillar structures 124 are encapsulated in a first encapsulant layer (e.g., encapsulant layer 114-1) and, subsequently, a second molding step in which the thick pillar structures 128 and RDL are encapsulated in a second encapsulant layer (e.g., encapsulant layer 114-2), which forms a portion of the mounting surface 106 along with the exposed "top" surfaces of the thick pillar structures 128. The encapsulant(s) employed in these one or more encapsulant layers can include any of a variety of suitable encapsulant materials or combination thereof, such as plastics, epoxy resins, ceramics, and the like. It should be noted that reference to a structure being "encapsulated" by an encapsulant or encapsulant layer does not require that the structure be wholly encapsulated by the encapsulant or encapsulant layer. To illustrate, the encapsulant layer 114-2 is described as encapsulating the thick pillar structures 128 even though the top surface and at least one side surface of each thick pillar structure is not covered or concealed in encapsulant, that is, the top surface and at least one side surface is exposed to the outside of the package 102 (or, in some embodiments, such otherwise exposed surfaces are plated with solder plating, as described below)

The implementation of the dual-sided stud structures 112 for contact fan-out from the active surface 120 of the IC die 104 to the comparably larger mounting surface 106 of the package 102 results in the thick pillar structures 128 serving as the surface mount pads for establishing mechanical and electrical connections between a circuit board and the package 102 mounted thereon. The relatively long vertical dimensions (that is, dimensions parallel to a plane orthogonal to the active surface 120 or mounting surface 106, or along the indicated Z-direction) of these thick pillar structures 128 thus facilitate sidewall wetting during the soldering process. Moreover, due to their relatively thick lateral dimensions, during the fabrication process wettable sidewall flanks 144, such as sidewall flanks 144-1 and 144-2, can be formed in the exterior sidewalls of the thick pillar structures 128. These sidewall flanks 144 are formed as rabbets in the edges of the sidewall of the thick pillar structures 128 and facilitate sidewall wettability by facilitating formation of a side solder fillet that can be visually inspected more readily. To further improve solderability, in some embodiments the external surfaces of the thick pillar structures 128 can be finished in an appropriate solder plating layer 146, such as a plating of tin (Sn), gold (Au), or the like.

Not only does the use of relatively thick and tall pillar structures facilitate sidewall wettability, these thick pillar structures 128 also provide for enhanced structural rigidity by virtue of their size and volume of rigid conductive material, and thus better protect the integrity of the package 102. For similar reasons, the dual-sided stud structures 112 provide enhanced EM isolation for the IC die 104 in the presence of potential EM interference from the circuit board or other components mounted thereon.

FIG. 2 illustrates a bottom view 200 of the package 102 in accordance with some embodiments. As described, the mounting surface 106 is formed from a bottom surface of the package encapsulant layer 114-2 along with the exposed "bottom" surfaces of the thick pillar structures 128 of the dual-sided stud structures 112 (and, in some instances, separate dummy thick pillar structures). As the bottom exterior surfaces of the thick pillar structures 128 are co-planar, or flush, with the mounting surface 106 and thus exposed through the package encapsulant 114 at the mounting surface 106, the bottom exterior surfaces of the thick pillar structures 128 serve as surface mount pads 228 at the perimeter of the package 102, such as the bottom exterior surfaces of the thick pillar structures 128-1 to 128-5 serving as surface mount pads 228-1 to 228-5, respectively. Moreover, as at least one side surface of the thick pillar structures 128, or "sidewall", is co-planar with a corresponding side surface of the package 102 and thus exposed, the exposed sidewalls of the thick pillar structures 128 may serve as wettable sidewalls for soldering purposes. This sidewall wettability may be further enhanced by the sidewall flanks 144 formed in the external-facing sides of the thick pillar structures 128, such as the sidewall flanks 144-1 and 144-2 in the thick pillar structures 128-2 and 128-4 as previously illustrated in cross-section view 100 of FIG. 1, respectively, as well as the sidewall flanks 144-3, 144-4, 144-5, 144-6, and 144-7 formed in the thick pillar structures 128-2, 128-4, 128-1, 128-5, and 128-3, respectively, along the bottom edge of the package 102. Note that although a surface mount pad configuration having five surface mount pads 228 to a side (for a total of 16 surface mount pads 228) is illustrated, it will be appreciated that a semiconductor package fabricated in accordance with the teachings provided herein can include any of a variety of pad number/array configurations.

FIG. 3 illustrates a cross-section view 300 of an electronic device 302 having a circuit board 304 with the package 102 mounted thereon in accordance with at least some embodiments. As illustrated, the package 102 is surface mounted to the circuit board 304. Accordingly, the package 102 is positioned and oriented such that the mounting surface 106 of the package 102 faces a corresponding surface 306 of the circuit board 304. Each of at least a subset of the package surface mount pads 228 formed by the external surface of a corresponding thick pillar structure 128 of a double-sided stud structure 112 is electrically and mechanically connected to a corresponding pad of the circuit board 304 via a corresponding solder bump or other conductive structure, and thus providing an electrically conductive path between the pad and circuitry of the IC die 104 via the conductive components of the double-sided stud structure 112. For example, the thin pillar structure 124-1 and the thick pillar structures 128-1 and 128-2 of the double-sided stud structure 128-1 and the solder bumps 310-1 and 310-2 form conductive pathways between the contact 118-1 of the IC die 104 and pads 308-1 and 308-2, respectively, of the circuit board 304. As also illustrated by solder bump 310-2, the sidewall flanks 144 (e.g., sidewall flank 144-1) formed in the external peripheral sides of the thick pillar structures 128 facilitates sidewall solder wetting and thus not only facilitates improved solder joints but also facilitates visual inspection of such solder joints. Further, although not depicted for ease of illustration, a dielectric underfill material may be deposited between the package 102 and the circuit board 304 to provide a stronger mechanical bond and to further isolate the individual electrical connections between the package 102 and the circuit board 304.

FIGs. 4 and 5 together illustrate a method 400 of fabrication of a leadless semiconductor package employing conductive dual-sided stud structures for fan-out die-to-surface connectivity and package surface mounting in accordance with some embodiments. For ease of illustration, the method 400 is described with reference to the package 102 of FIGs. 1-3, but the method 400 is not limited to this example description. Moreover, at least by virtue of their ability to be built-up layer-by-layer, the use of the double-sided stud structures 112 allows the resulting semiconductor package to be readily fabricated using a fan-out panel-level-packaging (FO-PLP) process, and thus the fabrication process of method 400 will be described in the context of a PLP fabrication process. However, it will be appreciated that other packaging processes, such as wafer-level packaging (WLP) processes may be employed to fabricate similar semiconductor packages using the guidelines provided herein.

The method 400 initiates with the fabrication or other obtainment of a workpiece 403 implementing the IC die 104. To illustrate, in some embodiments, a wafer containing a plurality of instances of the IC die 104 is fabricated, tested, and singulated to generate a plurality of instances of tested, known-good IC die 104, from which the particular IC die 104 of workpiece 401 is selected. At block 402 ("thin pillar build up from active layer of die"), one or more processes are performed to build-up or otherwise form the thin pillar structures 124 aligned with, and in electrical and mechanical contact with, the contacts 118 of the active surface 120 of the IC die 104. Any of a variety of fabrication processes known in the art can be utilized to form the thin pillar structures 124, such as processes that utilize chemical vapor deposition (CVD), physical vapor deposition (PVD), photolithographic-based masking and etching, laser or mechanical drilling, metal sputtering, metal plating, and the like. For example, in some implementations, the thin pillar structures 124 are formed from a series of processes, including a film lamination process, a laser drilling process, a sputtering process to deposit a combination of titanium (Ti) and copper (Cu) in the holes and then a corresponding develop process, followed by a copper plating process.

In a FO-PLP process, a round or rectangular panel of IC dice is reconstructed from a plurality of separate and individual IC dice via a pick-and-place process that positions a plurality of IC dice in an array formation within a mold panel and then a molding process is performed to form at least an initial molding, or encapsulant, layer. Accordingly, at block 404 ("reconstruction on mold panel with first encapsulation layer"), a plurality of instances of the workpiece 401 are reconstructed into a large mold frame having a panel carrier 405 and the plurality of instances of the workpiece 401 then are overmolded in an encapsulant (or "molding compound"), such as epoxy, resulting in a reconstructed panel having an array of instances of workpiece 403 composed of the workpiece 401 (the IC die 104 and the built-up thin pillar structures 124) encapsulated in a first encapsulant layer 407 (which, after singulation as described below, becomes the first encapsulant layer 114-2).

At block 406 ("redistribution and thick pillar build up"), any of a variety of well-known redistribution processes are performed on the resulting workpiece 409 (as part of the reconstructed panel) to form the metallizations and insulating layer(s) of the one or more RDLs to be implemented in the resulting package. Thereafter, one or more processes are performed to build up the thick pillar structures 128 of the double-sided stud structures. Such processes can include one or more CVD processes, PVD processes, photolithographic mask/etch processes, laser drilling or mechanical drilling processes, sputtering processes, plating processes, and the like. In some embodiments, a surface grind process or similar process is performed to planarize the "top" surface of the workpiece to create a more planar mounting surface for the resulting package. In such instances, the build-up of the thick pillar structures 128 can include over-building the height ("vertical" dimension) of the thick pillar structures 128 beyond their final intended height (as represented by line 411) so as to compensate for the loss of material at the "top" of the thick pillar structures 128 as a result of the surface grind process. The metallizations of the one or more RDLs are configured so that one or more of the built-up thin pillar structures 124 are electrically and mechanically connected to one or more corresponding thick pillar structures 128, with each set of electrically and mechanically connected thin pillar structure(s) 124, RDL metallizations, and thick pillar structure(s) 128 forming a corresponding dual-sided stud structure 112.

At block 408 ("overmolding of second encapsulation layer, surface grinding"), the built-up thick pillar structures 128 of the resulting workpiece 409 are overmolded with encapsulant to form a second encapsulant layer 413 (which, after singulation as described below, becomes the second encapsulant layer 114-2) that encapsulates the thick pillar structures 128 and a surface grind process is performed at the top surface of the workpiece 409 to provide a planar and level, or substantially planar and level, surface, with this surface grind process removing some of the second encapsulant layer and the over-built regions of the thick pillar structures 128 (up to line 411), resulting in workpiece 415 having a planar mounting surface at which the top surfaces of the thick pillar structures are exposed.

Turning now to FIG. 5, the method 400 continues at block 410 ("back side lamination, laser marking") with the workpiece 415 subjected to a backside lamination process in which the array of instances of workpiece 415 is removed from the panel carrier and, in some embodiments, a protective BSL layer 417 (which will become BSL layer 116 after singulation) is formed at the "backside" surface (that is, proximate to the IC die 104) so as to protect the IC die 104, resulting in an array of instances of workpiece 419. Other backside processes, such as laser marking, stamping, etc., also may be performed.

As shown by FIG. 5, in the reconstructed panel (panel 421) adjacent instances of the workpiece 419 may be fabricated such that a wider pillar structure is formed to provide for two adjacent thick pillar structures 128 that each are in a different instance of the workpiece 419 and will be so separated during the panel singulation process. To illustrate, the depicted panel 421 includes two adjacent workpieces 419-1 and 419-2, and implements a single wider pillar structure 423 that, after singulation, will result in a corresponding thick pillar structure 128 for the workpiece 419-1 and a separate corresponding thick pillar structure 128 for the workpiece 419-2. The method 400 can leverage this use of a single wider pillar structure that will subsequently be singulated into two separate thick pillar structures to facilitate the wettable sidewall flank formation process by, at block 412 ("sidewall flank formation, solder plating"), forming grooves, such as groove 425, at the singulation lines, or boundaries, between instances of the workpiece 419 in the panel 421 at which singulation will occur to separate panel 421 into separate, individual packages. The grooves so formed have dimensions compatible with the desired dimensions of the sidewall flanks that subsequently result from the grooves. The grooves may be formed using, for example, in which a singulation blade having a kerf with the desired groove thickness is used to cut a partial-cut to the desired groove depth. As another example, a chemical etching process may be employed to obtain grooves of the desired dimensions in the wider pillar structures at the boundaries between workpieces. A similar singulation saw cut or chemical etch process may be employed at the edges of the instances of the workpieces 419 at the perimeter of the panel 421. Further, a CVP process, PVD process, or other well-known process may be employed to deposit gold (Au), tin (Sn), or another appropriate solder plating material on the top surface of the panel 421 so as to form a solder plating layer (omitted from FIG. 5, see solder plating layer 146, FIG. 1) on the exposed top and sidewall surfaces of the thick pillar structures 128.

At block 414 ("singulation, chip sort"), a saw-based or laser-based singulation process is performed to singulate the individual instances of the workpieces 419, such as along singulation line 427. Each singulated workpiece 419 thus becomes a corresponding instance of the semiconductor package 102, such as workpieces 419-1 and 419-2 becoming semiconductor packages 102-1 and 102-2, respectively. Each instance of the semiconductor package 102 then may be subjected one or more chip sorting or other testing processes so as to identify known-good packages suitable for use for their intended purposes.

## Claims

1. A leadless semiconductor package comprising:
an integrated circuit, IC, die (104) having one or more contacts (118-1, 118-2) at an active surface (120) facing a mounting surface of the leadless semiconductor package; and
a plurality of dual-sided stud structures providing electrical connectivity between the
IC die and the mounting surface, each dual-sided stud structure having at least one first conductive pillar structure (124-1, 124-2) extending from a corresponding contact (118-1, 118-2) at the active surface (120) to a redistribution layer and having a plurality of second conductive pillar structures (128-1, 128-2, 128-3, 128-4) extending from a redistribution layer to an edge of the mounting surface, such second conductive pillar structures being electrically and mechanically connected to each other via a metal trace (136) of at least one redistribution layer and to the first conductive pillar structure through the at least one redistribution layer;
wherein each first conductive pillar structure (124-1, 124-2) has a first dimension in a direction parallel to the mounting surface that is less than a corresponding second dimension of each second conductive pillar structure, wherein each second conductive pillar structure comprises a solder wettable flank (144-1, 144-2) at an exterior sidewall;
a first encapsulant layer (114-1) encapsulating the active surface (120) of the IC die and the first pillar structures (124-1, 124-2) of the plurality of dual-sided stud structures; and
a second encapsulant layer (114-2) encapsulating the second pillar structures (128-1, 128-2, 128-3, 128-4) of the plurality of dual-sided stud structures and forming a portion of the mounting surface.

2. The leadless semiconductor package of claim 1, further comprising solder plating (308-1, 308-2) on exterior surfaces of the second conductive pillar structures (128-1, 128-2, 128-3, 128-4) that are parallel to the mounting surface and on surfaces of the solder wettable flanks (144-1, 144-2) of the second conductive pillar structures.

3. The leadless semiconductor package of claim 1 or claim 2, wherein the second dimension is at least two times larger than the first dimension.

4. The leadless semiconductor package of claim 1 or claim 2, wherein the second dimension is at least three times larger than the first dimension.

5. An electronic device (302) comprising a circuit board (304) having the leadless semiconductor package of any preceding claim mounted thereon.

6. A method of fabricating a leadless semiconductor package, the method comprising:
forming (402) a plurality of first pillar structures extending from contacts at an active surface of an integrated circuit, IC, die;
encapsulating (404) the IC die and the plurality of first pillar structures in a first encapsulant layer;
forming (406) one or more redistribution layers at a surface of the first encapsulant layer opposite the IC die, the one or more redistribution layers having metallizations electrically and mechanically connected to one or more corresponding first pillar structures of the first plurality of pillar structures;
forming (406) a plurality of second pillar structures extending from the one or more redistribution layers, each second pillar structure electrically and mechanically connected to each other via a metal trace of at least one redistribution layer and connected to one or more first pillar structures via at least one redistribution layer and having a second dimension in a direction parallel to the active surface that is greater than a corresponding first dimension of each first conductive pillar structure;
encapsulating (408) the plurality of second pillar structures in a second encapsulant layer; and
planarizing the second encapsulant layer and the plurality of second pillar structures to form (410) a mounting surface for the leadless semiconductor package with exposed surfaces of the plurality of the second pillar structures serving as surface mount pads for the leadless semiconductor package
forming (412) solder wettable flanks in exposed sidewalls of the plurality of second pillar structures.

7. The method of claim 6, further comprising:
solder plating exposed surfaces of the plurality of the second pillar structures including the solder wettable flanks.

8. The method of claim 6 or claim 7, further comprising:
forming a reconstructed panel comprising a plurality of workpieces including a workpiece representing the leadless semiconductor package;
singulating the reconstructed panel after planarizing the second encapsulant layer and the plurality of second pillar structures to generate a plurality of leadless semiconductor packages from the plurality of workpieces; and
wherein forming the solder wettable flanks comprises forming grooves along singulation lines in metal material representing second pillar structures from adjacent workpieces prior to singulating the reconstructed panel.

9. The method of claim 8, wherein forming grooves comprises at least one of: performing chemical etches to form the grooves; or performing singulation cuts to partial depth to form the grooves.

10. The method of any of claims 6 to 9, wherein the second dimension is at least two times the first dimension.

11. The method of any of claims 6 to 9, wherein the second dimension is at least three times the first dimension.

## Patentansprüche

1. Leitungsloses Halbleitergehäuse, das Folgendes umfasst:
einen integrierten Schaltungs-Die, IC-Die, (104) mit einem oder mehreren Kontakten (118-1, 118-2) an einer aktiven Oberfläche (120), die einer Montageoberfläche des leitungslosen Halbleitergehäuses zugewandt ist; und
eine Mehrzahl doppelseitiger Bolzenstrukturen, die eine elektrische Konnektivität zwischen dem IC-Die und der Montageoberfläche bereitstellen, wobei jede doppelseitige Bolzenstruktur mindestens eine erste leitfähige Säulenstruktur (124-1, 124-2) aufweist, die sich von einem entsprechenden Kontakt (118-1, 118-2) an der aktiven Oberfläche (120) zu einer Umverteilungsschicht erstreckt und mehrere zweite leitfähige Säulenstrukturen (128-1, 128-2, 128-3, 128-4) aufweist, die sich von einer Umverteilungsschicht zu einer Kante der Montageoberfläche erstrecken, wobei solche zweiten leitfähigen Säulenstrukturen elektrisch und mechanisch über eine Metallbahn (136) von mindestens einer Umverteilungsschicht und mit der ersten leitfähigen Säulenstruktur durch die mindestens eine Umverteilungsschicht miteinander verbunden sind;
wobei jede erste leitfähige Säulenstruktur (124-1, 124-2) eine erste Abmessung in einer Richtung parallel zu der Montageoberfläche aufweist, die kleiner als eine entsprechende zweite Abmessung jeder zweiten leitfähigen Säulenstruktur ist, wobei jede zweite leitfähige Säulenstruktur eine lotbenetzbare Flanke (144-1, 144-2) an einer äußeren Seitenwand umfasst;
eine erste Verkapselungsschicht (114-1), die die aktive Oberfläche (120) des IC-Dies und die ersten Säulenstrukturen (124-1, 124-2) der Mehrzahl von doppelseitigen Bolzenstrukturen verkapselt; und
eine zweite Verkapselungsschicht (114-2), die die zweiten Säulenstrukturen (128-1, 128-2, 128-3, 128-4) der Mehrzahl von doppelseitigen Bolzenstrukturen verkapselt und einen Teil der Montageoberfläche bildet.

2. Leitungsloses Halbleitergehäuse nach Anspruch 1, ferner umfassend ein Lotplattieren (308-1, 308-2) auf Außenflächen der zweiten leitfähigen Säulenstrukturen (128-1, 128-2, 128-3, 128-4), die parallel zu der Montagefläche und auf Oberflächen der lotbenetzbaren Flanken (144-1, 144-2) der zweiten leitfähigen Säulenstrukturen sind.

3. Leitungsloses Halbleitergehäuse nach Anspruch 1 oder Anspruch 2, wobei die zweite Abmessung mindestens zweimal größer als die erste Abmessung ist.

4. Leitungsloses Halbleitergehäuse nach Anspruch 1 oder Anspruch 2, wobei die zweite Abmessung mindestens dreimal größer als die erste Abmessung ist.

5. Elektronische Vorrichtung (302), umfassend eine Leiterplatte (304), auf der das leitungslose Halbleitergehäuse nach einem der vorhergehenden Ansprüche montiert ist.

6. Verfahren zum Fertigen eines leitungslosen Halbleitergehäuses, wobei das Verfahren Folgendes umfasst:
Bilden (402) einer Mehrzahl von ersten Säulenstrukturen,
die sich von Kontakten an einer aktiven Oberfläche eines IC-Dies erstrecken;
Verkapseln (404) des IC-Dies und der Mehrzahl von ersten Säulenstrukturen in einer ersten Verkapselungsschicht;
Bilden (406) einer oder mehrerer Umverteilungsschichten an einer Oberfläche der ersten Verkapselungsschicht gegenüber dem IC-Die, wobei die eine oder die mehreren Umverteilungsschichten Metallisierungen aufweisen, die elektrisch und mechanisch mit einer oder mehreren entsprechenden ersten Säulenstrukturen der ersten Mehrzahl von Säulenstrukturen verbunden sind;
Bilden (406) einer Mehrzahl von zweiten Säulenstrukturen, die sich von der einen oder den mehreren Umverteilungsschichten erstrecken, wobei jede zweite Säulenstruktur elektrisch und mechanisch über eine Metallspur mindestens einer Umverteilungsschicht miteinander verbunden ist und über mindestens eine Umverteilungsschicht mit einer oder mehreren ersten Säulenstrukturen verbunden ist und eine zweite Abmessung in einer Richtung parallel zu der aktiven Oberfläche aufweist, die größer als eine entsprechende erste Abmessung jeder ersten leitfähigen Säulenstruktur ist;
Verkapseln (408) der Mehrzahl von zweiten Säulenstrukturen in einer zweiten Verkapselungsschicht; und
Planarisieren der zweiten Verkapselungsschicht und der Mehrzahl von zweiten Säulenstrukturen, um eine Montageoberfläche für das leitungslose Halbleitergehäuse zu bilden (410), wobei freiliegende Oberflächen der mehreren zweiten Säulenstrukturen als Oberflächenmontagepads für das leitungslose Halbleitergehäuse dienen
Bilden (412) von lotbenetzbaren Flanken in freiliegenden Seitenwänden der Mehrzahl von zweiten Säulenstrukturen.

7. Verfahren nach Anspruch 6, ferner umfassend:
Lotplattieren freiliegender Oberflächen der Mehrzahl von zweiten Säulenstrukturen einschließlich der lotbenetzbaren Flanken.

8. Verfahren nach Anspruch 6 oder Anspruch 7, ferner umfassend:
Bilden einer rekonstruierten Platte, die mehrere Werkstücke umfasst, die ein Werkstück beinhalten, das das leitungslose Halbleitergehäuse repräsentiert;
Vereinzeln der rekonstruierten Platte nach dem Planarisieren der zweiten Verkapselungsschicht und der Mehrzahl von zweiten Säulenstrukturen, um mehrere leitungslose Halbleitergehäuse aus der Mehrzahl von Werkstücken zu erzeugen; und
wobei das Bilden der lotbenetzbaren Flanken das Bilden von Nuten entlang Vereinzelungslinien in Metallmaterial umfasst, das zweite Säulenstrukturen von benachbarten Werkstücken repräsentiert, bevor die rekonstruierte Platte vereinzelt wird.

9. Verfahren nach Anspruch 8, wobei das Bilden von Nuten mindestens eines von Folgendem umfasst: Durchführen chemischer Ätzungen, um die Nuten zu bilden; oder Durchführen von Vereinzelungsschnitten bis zu einer teilweisen Tiefe, um die Nuten zu bilden.

10. Verfahren nach einem der Ansprüche 6 bis 9, wobei die zweite Abmessung mindestens das Zweifache der ersten Abmessung beträgt.

11. Verfahren nach einem der Ansprüche 6 bis 9, wobei die zweite Abmessung mindestens das Dreifache der ersten Abmessung beträgt.

## Revendications

1. Boîtier à semi-conducteur sans broches comprenant :
une puce de circuit intégré, CI, (104) pourvue d'un ou de plusieurs contacts (118-1, 118-2) au niveau d'une surface active (120) faisant face à une surface de montage du boîtier à semi-conducteur sans broches ; et
une pluralité de structures de plot double face assurant une connectivité électrique entre la puce de CI et la surface de montage, chaque structure de plot double face étant pourvue d'au moins une première structure de pilier conductrice (124-1, 124-2) s'étendant depuis un contact (118-1, 118-2) correspondant, au niveau de la surface active (120), jusqu'à une couche de redistribution et pourvue d'une pluralité de deuxièmes structures de pilier conductrices (128-1, 128-2, 128-3, 128-4) s'étendant depuis une couche de redistribution jusqu'à un bord de la surface de montage, ces deuxièmes structures de pilier conductrices étant connectées électriquement et
mécaniquement les unes aux autres via une piste métallique (136) d'au moins une couche de redistribution et à la première structure de pilier conductrice par l'intermédiaire de l'au moins une couche de redistribution ;
chaque première structure de pilier conductrice (124-1, 124-2) étant pourvue d'une première dimension dans une direction parallèle à la surface de montage qui est inférieure à une deuxième dimension correspondante de chaque deuxième structure de pilier conductrice, chaque deuxième structure de pilier conductrice comprenant un flanc mouillable à la soudure (144-1, 144-2) au niveau d'une paroi latérale extérieure ;
une première couche d'encapsulant (114-1) encapsulant la surface active (120) de la puce de CI et les premières structures de pilier (124-1, 124-2) de la pluralité de structures de plot double face ; et
une deuxième couche d'encapsulant (114-2) encapsulant les deuxièmes structures de pilier (128-1, 128-2, 128-3, 128-4) de la pluralité de structures de plot double face et formant une portion de la surface de montage.

2. Boîtier à semi-conducteur sans broches selon la revendication 1, comprenant en outre un placage de soudure (308-1, 308-2) sur des surfaces extérieures des deuxièmes structures de pilier conductrices (128-1, 128-2, 128-3, 128-4) qui sont parallèles à la surface de montage et sur des surfaces des flancs mouillables à la soudure (144-1, 144-2) des deuxièmes structures de pilier conductrices.

3. Boîtier à semi-conducteur sans broches selon la revendication 1 ou la revendication 2, dans lequel la deuxième dimension est au moins deux fois supérieure à la première dimension.

4. Boîtier à semi-conducteur sans broches selon la revendication 1 ou la revendication 2, dans lequel la deuxième dimension est au moins trois fois supérieure à la première dimension.

5. Dispositif électronique (302) comprenant une carte de circuit imprimé (304) sur laquelle est monté le boîtier à semi-conducteur sans broches selon l'une quelconque des revendications précédentes.

6. Procédé de fabrication d'un boîtier à semi-conducteur sans broches, le procédé comprenant :
la formation (402) d'une pluralité de premières structures de pilier s'étendant depuis des contacts au niveau d'une surface active d'une puce de circuit intégré, CI ;
l'encapsulation (404) de la puce de CI et de la pluralité de premières structures de pilier dans une première couche d'encapsulant ;
la formation (406) d'une ou de plusieurs couches de redistribution au niveau d'une surface de la première couche d'encapsulant opposée à la puce de CI, la ou les couches de redistribution étant pourvues de métallisations connectées électriquement et
mécaniquement à une ou plusieurs premières structures de pilier correspondantes de la première pluralité de structures de pilier ;
la formation (406) d'une pluralité de deuxièmes structures de pilier s'étendant depuis la ou les couches de redistribution, chaque deuxième structure de pilier étant connectée électriquement et mécaniquement aux autres via une piste métallique d'au moins une couche de redistribution et connectée à une ou plusieurs premières structures de pilier via au moins une couche de redistribution et pourvue d'une deuxième dimension dans une direction parallèle à la surface active supérieure à une première dimension correspondante de chaque première structure de pilier conductrice ;
l'encapsulation (408) de la pluralité de deuxièmes structures de pilier dans une deuxième couche d'encapsulant ; et
la planarisation de la deuxième couche d'encapsulant et de la pluralité de deuxièmes structures de pilier pour former (410) une surface de montage pour le boîtier à semi-conducteur sans broches, des surfaces exposées de la pluralité de deuxièmes structures de pilier servant de pastilles de montage en surface pour le boîtier à semi-conducteur sans broches
la formation (412) de flancs mouillables à la soudure dans des parois latérales exposées de la pluralité de deuxièmes structures de pilier.

7. Procédé selon la revendication 6, comprenant en outre :
le placage à la soudure de surfaces exposées de la pluralité des deuxièmes structures de pilier comportant les flancs mouillables à la soudure.

8. Procédé selon la revendication 6 ou la revendication 7, comprenant en outre :
la formation d'un panneau reconstruit comprenant une pluralité de pièces comportant une pièce représentant le boîtier à semi-conducteur sans broches ;
la singularisation du panneau reconstruit après planarisation de la deuxième couche d'encapsulant et de la pluralité de deuxièmes structures de pilier afin de générer une pluralité de boîtiers à semi-conducteur sans broches à partir de la pluralité de pièces ; et
la formation des flancs mouillables à la soudure comprenant la formation de rainures le long de lignes de singularisation dans un matériau métallique représentant des deuxièmes structures de pilier à partir de pièces adjacentes avant la singularisation du panneau reconstruit.

9. Procédé selon la revendication 8, dans lequel la formation de rainures comprend au moins l'une des opérations suivantes : la réalisation de gravures chimiques pour former les rainures ; ou la réalisation de découpes de singularisation jusqu'à une profondeur partielle pour former les rainures.

10. Procédé selon l'une quelconque des revendications 6 à 9, dans lequel la deuxième dimension est d'au moins deux fois la première dimension.

11. Procédé selon l'une quelconque des revendications 6 à 9, dans lequel la deuxième dimension est d'au moins trois fois la première dimension.
